# EUROPEAN PATENT SPECIFICATION

(11) **EP 3 378 156 B1**
(45) Date of publication and mention of the grant of the patent: **30.12.2020**
(21) Application number: 16801089.0
(22) Date of filing: 08.11.2016
(51) Int. Cl.: H01L 21/8234, H01L 21/8252, H01L 27/06, H01L 29/20, H01L 29/812, H03F 1/56, H03F 3/195, H03F 3/213, H03F 1/32, H01L 29/872

(54) **FIELD EFFECT TRANSISTOR (FET) STRUCTURE WITH INTEGRATED GATE CONNECTED DIODES**
FELDEFFEKTTRANSISTOR (FET)-STRUKTUR MIT INTEGRIERTEN GATE-VERBUNDENEN DIODEN
STRUCTURE DE TRANSISTORS À EFFET DE CHAMP (TEC) À DIODES CONNECTÉES AUX GRILLES INTÉGRÉES

(30) Priority: 20.11.2015 US 201514947197
(43) Date of publication of application: 26.09.2018
(73) Proprietor: Raytheon Company, Waltham, MA 02451-1449 (US)
(72) Inventor: BETTENCOURT, John P., Danvers, Massachusetts 01923 (US); MALLAVARPU, Raghuveer, Boxborough, Massachusetts 01719-2014 (US)
(74) Representative: Carpmaels & Ransford LLP
(86) International application number: PCT/US2016/060959
(87) International publication number: WO 2017/087205

(56) References cited:
- US-A- 5 111 253
- US-A1- 2005 167 742
- US-A1- 2011 220 978
- US-A1- 2015 137 310
- MRUNAL A K ET AL: "Power Amplifier Linearization Using a Diode", ELECTROTECHNICAL CONFERENCE, 2006. MELECON 2006. IEEE MEDITERRANEAN BENALMADENA, SPAIN 16-19 MAY 2006, PISCATAWAY, NJ, USA,IEEE, 16 May 2006 (2006-05-16), pages 173-176, XP010927717, DOI: 10.1109/MELCON.2006.1653064 ISBN: 978-1-4244-0087-4 cited in the application
- Christopher Burke Haskins ET AL: "Diode Predistortion Linearization for Power Amplifier RFICs in Digital Radios", , 26 April 2000 (2000-04-26), XP055335756, Retrieved from the Internet: URL:https://pdfs.semanticscholar.org/be1c/ 5f63bc21e961bead37b3c4b3d9f3fe7b489c.pdf [retrieved on 2016-01-18]

## Description

### TECHNICAL FIELD

This disclosure relates generally to Field Effect Transistor amplifiers and more particularly to FET amplifiers having integrated diodes.

### BACKGROUND

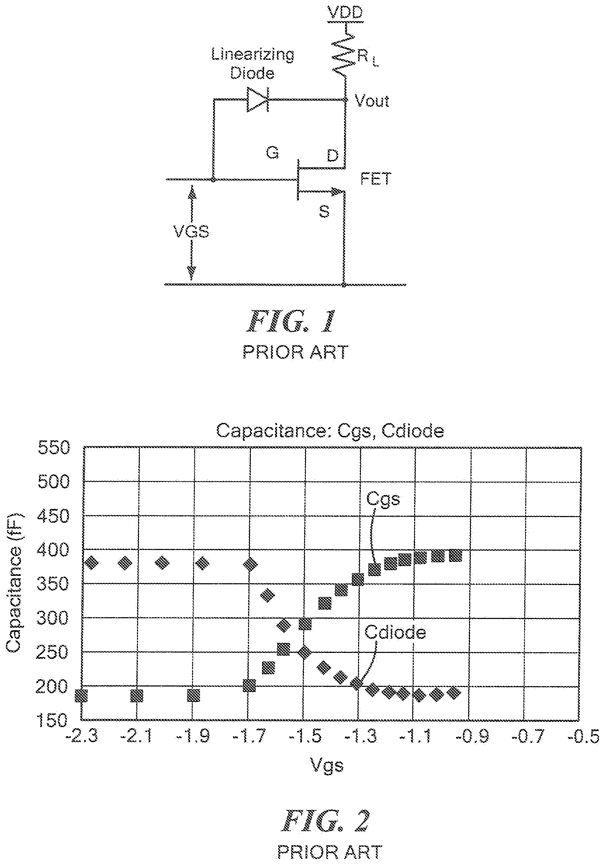

As is known in the art, an important requirement for a Radio Frequency (RF) Transistor Amplifier design is the linear operation of the amplifier. Common design or system techniques to enhance linearity performance are feedback, feedforward or pre-distortion. A common pre-distortion technique involves adding a linearizing diode circuit to the input of a FET amplifier, as shown in FIG. 1. Here the diode anode is connected near the gate of amplifier FET and the cathode is connected near the drain.

More particularly, during RF stimulus the FET gate to source capacitance (Cgs) will vary non-linearly, typically following a hyperbolic tangent curve, with gate voltage. A plot of this non-linear gate to source voltage (Vgs) vs. the capacitance in femtofarads (fF) between the gate and source (Cgs) relationship for a GaN HEMT is shown in FIG. 2. This non-linear varying capacitance degrades amplifier linear operation. An additional parallel capacitance (C diode) which varies inverse to the variation of Cgs with Vgs can be introduced at the input of the FET or amplifier to compensate for the above-described undesirable gate to source capacitance variation. This additional capacitance (C diode) is supplied by adding a linearizing diode at the input to the FET; the diode(C diode) providing an anode to cathode capacitance having the inverse non-linear relationship when the anode of the diode shares the gate node of the FET and the cathode of the diode share the drain node of the FET. Since the FET gate and diode anode nodes are shared, their respective non-linear capacitances add together resulting in a linear capacitance verses gate to source voltage at the gate node. This linearized input capacitance can result in a more linear amplifier operation, see Mural, ASK; Shirasgaonkar, M.; Patrikar, "Power Amplifier Linearization using a Diode", IEEE MELECON 2006, May 16-19, Benalmádena (Málaga), Spain and Akihro Ando, Yoichiro Takayama, Tsuyoshi Yoshida, Ryo Ishikawa, and Kazuhiko Honjo, A High-Efficiency Class-F GaN HEMT Power "Amplifier with a Diode Predistortion Linearizer", Microwave Conference, 2008, APMC 2008. Asia-Pacific.

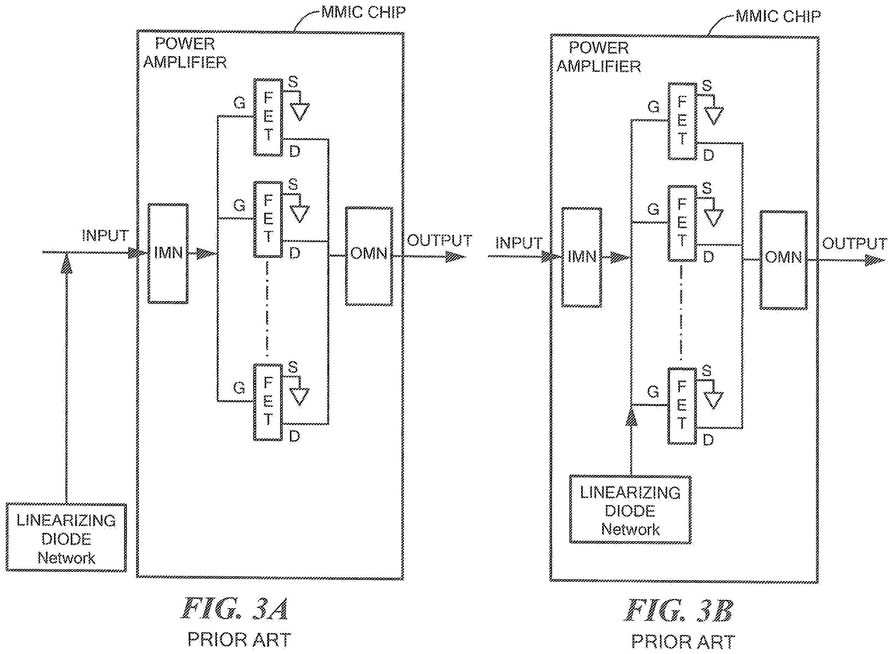

It is also known in the art, a plurality of FETs may be arranged as a Monolithic Microwave Integrated Circuit (MMIC) chip power amplifier, as shown in FIG. 3A. Here, the RF input signal is fed to an input matching network (IMN), the output of which is fed equally to the input of each one of the plurality of plural cell FETs. The outputs of each one of the plurality of plural cell FETs are combined and fed to an output matching network (OMN), as shown. The linearizing diode, described above, is connected to the input of the amplifier either "off" the MMIC chip, as shown in FIG. 3A, or "on" the MMIC chip (FIG. 3D) as described in a paper entitled "High linearity GaN HEMT power amplifier with pre-linearization gate diode", Shouxuan Xie, Vamsi Paidi, Sten Heikman, Alessandro Chini, Umesh K. Mishra, Mark J. W. Rodwell and Stephen I. Long, published in High Performance Devices, 2004. Proceedings IEEE Lester Eastman Conference, 4-6 Aug. 2004, pages 223 - 228.

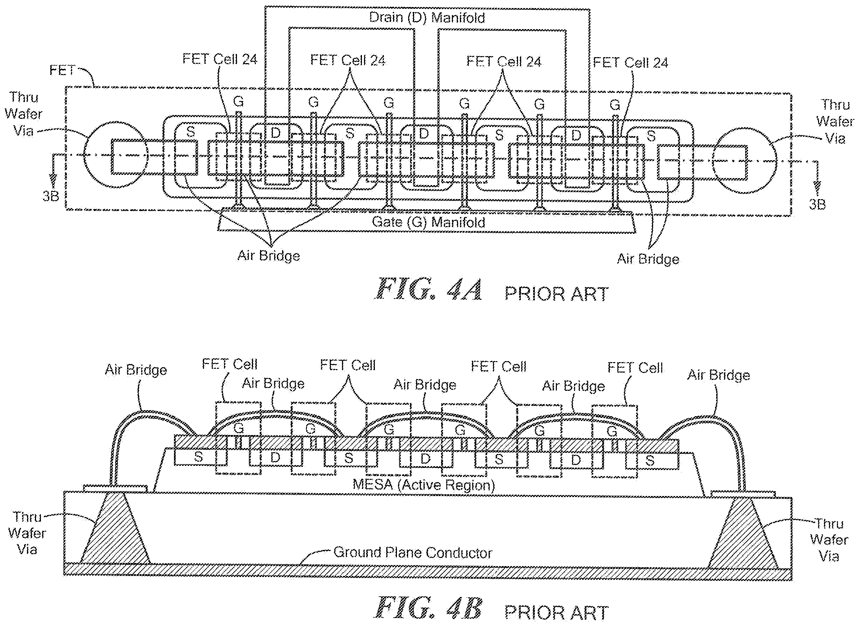

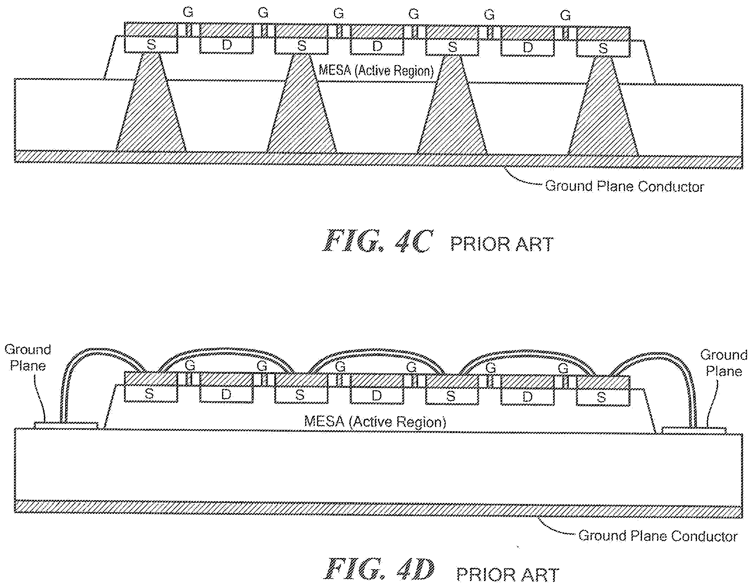

As is also known in the art, one type of FET includes a plurality of linearly arranged FET cells (herein sometimes referred to as a plural cell FET) as shown in FIGS. 4A and 4B on a semiconductor, here a GaN, mesa hetero- structure, as shown, which provides an active region for the FET. Here, ends of gate finger-like electrodes are connected to a common gate manifold contact pad. Each gate finger-like electrodes (G) controls a flow of carriers in a channel region between a source region (S) and a drain region (D). Drain and source electrodes are in ohmic contact with the FET drain and source regions; and the gate finger-like electrodes (G) are in Schottky contact with the gate regions The drain electrodes have ends thereof connected to a drain manifold contact and the source regions are interconnected by air bridges as shown. The end ones of the source region (S) are connected to a ground plane conductor on the bottom surface of a substrate with electrically conductive vias, as shown. However, alternatively, each one of the source regions (S) may be connected to the ground plane on the bottom surface of the substrate as shown in FIG. 4C or alternatively, the vias and ground plane may be removed as with a coplanar wave guide (CPW) transmission structure where the ground plane, not shown, is on the upper surface of the substrate, (FIG. 4D).

US 2011/220978 A1 relates to a semiconductor device in which a normally-on type FET, a capacitor having one electrode electrically connected to a gate of the FET and the other electrode electrically are connected to an input terminal. There is a diode having an anode electrode electrically connected to the gate of the FET and a cathode electrode electrically connected to a source of the FET that are formed on the same chip on which the FET is formed. Also, the capacitor may have a structure in which an insulation film such as a dielectric substance is formed on a gate drawn electrode of the FET, and a metallic layer is formed on the insulation layer.

US 2005/167742 A1 relates to power devices for use in a variety of power electronic applications. One such device combines a number of charge balancing techniques and other techniques for reducing parasitic capacitance to provide improved voltage performance, higher switching speed, and lower on-resistance.

US 5,111,253 A relates to a semiconductor power switching device that comprises a multicellular FET structure with a Schottky barrier diode structure interspersed therewith with at least some of the FET cells being free of Schottky barrier portions. The ratio of Schottky barrier contact area to FET cell area in the overall device may be adjusted to tailor the device for operation at specific current densities.

### SUMMARY

In accordance with the disclosure, a FET MMIC chip power amplifier is provided in accordance with the subject-matter of appended claim 1.

In one example, each one of the diodes is disposed proximate to the corresponding one of the FETs.

In one example, a structure is provided having: a plurality of field effect transistors (FETs) connected between a common input and a common output, each one of the field effect transistors comprising: a plurality of field effect transistor cells, each one of the FET cells comprising: a source region, a drain region, and a gate electrode for controlling carriers through a channel region of a transistor region of the structure between the source region and the drain region; and plurality of diodes, each one of the diodes being associated with a corresponding one of the plurality of FETs, each one of the diodes having an electrode in Schottky contact with a diode region of the corresponding one of the FETs.

In one example, a structure is provided having a plurality of field effect transistors (FETs) connected between a common input and a common output. Each one of the field effect transistors comprises a plurality of field effect transistor cells. Each one of the FET cells comprises: a source region, a drain region, and a gate electrode for controlling carriers through a channel region of a transistor region of the structure between the source region and the drain region; and a diode having an electrode in Schottky contact with a diode region of the FET cell.

With such an arrangement, rather than have one linearizing diode at the input of the amplifier to compensate for the Cgs vs. Vgs variation of all of the FETs in the amplifier, in accordance with the example, each one of the FETs has its own, associated linearizing diode. Thus, each one of the linearizing diodes is associated with, and is proximal to, a corresponding, individual one, of the FETs that requires Cgs vs. Vgs variation compensation.

In one example, a structure is provided having: a field effect transistor having a source region, a drain region, and a gate electrode for controlling carriers through a channel region of a transistor region of the structure between the source region and the drain region; and a diode having an electrode in Schottky contact with a diode region of the structure. The gate electrode and the diode electrode extend along parallel lines.

In one example, a structure is provided having a field effect transistor comprising: a source region; a drain region; and a gate electrode for controlling carriers through a channel region of a transistor region of the structure between the source region and the drain region. A diode is provided having an electrode in Schottky contact with a diode region of the structure. The source region, the drain region, the gate electrode, and the diode region are disposed along a common line.

In one example, the gate electrode and the diode electrode extend along parallel lines and wherein the common line is perpendicular to the parallel lines.

In one example, a structure is provided having; a plurality of field effect transistor cells, each one of the cells comprising: a source region, a drain region, and a gate electrode for controlling carriers through a channel region of a semiconductor region of the structure between the source region and the drain region, wherein the gate electrodes of the cells are parallel one to another; and wherein the gate electrodes have ends thereof connected to a common gate manifold pad. A diode is provided having: a first electrode in Schottky contact with a different portion of the semiconductor region to provide a cathode for the diode, the diode region being disposed between the drain region of one of the cells and the drain region of an adjacent one of the cells, said cathode electrode being electrically connected to the drain region of said one of the cells and the drain region of an said adjacent one of the cells through portions of the semiconductor region between said drain region of one of the cells and said drain region of an adjacent one of the cells; and a second electrode providing an anode for the diode being connected to the gate pad.

In one example, the second electrode is disposed along a line parallel to the gate electrodes.

In one example, a method is provided for forming a field effect transistor and a diode connected to the field effect transistor comprising forming a gate electrode of the field effect transistor in Schottky contact with a first semiconductor region on a substrate and a cathode electrode of the diode in Schottky contact with a second region of a semiconductor on the substrate during a common process step.

In one example, a structure is provided having a plurality of field effect transistor cells. A diode is disposed between a pair of adjacent ones of the cells.

In one example, the structure includes a semiconductor wherein one of the cells has a drain region in the semiconductor, a source region in the semiconductor and gate electrode in Schottky contact with a portion of a semiconductor between the source region and the drain region; and wherein the diode has a cathode in Schottky contact with a portion of the semiconductor adjacent to the drain region and an anode connected to the gate.

In one example, the gate has a predetermined width and the diode cathode has a predetermined width greater than the predetermined width of the gate.

In one example, the gate has a predetermined width and the diode cathode has a predetermined width at least an order of magnitude greater than the predetermined width of the gate.

The inventors have recognized that the linearizing Schottky diode capacitance per unit area is smaller relative to the unit area capacitance Cgs of the FET. Thus, the anode electrode of the diode, which is in Schottky contact with the semiconductor is much wider than the width of the gate finger-like electrodes, which are also in Schottky contact with the semiconductor; for example 10 to 100 times greater. Therefore, the diode provides a sufficiently large non-linear capacitance between the gate and the drain to completely balance out the Cgs variation with Vgs.

The details of one or more embodiments of the disclosure are set forth in the accompanying drawings and the description below. Other features, objects, and advantages of the disclosure will be apparent from the description and drawings, and from the claims.

### DESCRIPTION OF DRAWINGS

FIG. 1 is a schematic diagram of a Field Effect Transistor (FET) coupled to a linearizing diode according to the PRIOR ART;
FIG. 2 is a set of curves, one showing the non-linear Cgs and Cdiode (linearizing diode capacitance) vs Vgs for a Gallium Nitride FET according to the PRIOR ART;
FIGS. 3A and 3B are block diagrams of a FET power amplifier having a plurality of FETs with a linearizing diode according to the PRIOR ART;
FIGS. 4A is a top view of a plural cell FET according to the PRIOR ART;
FIG. 4B is a cross sectional view of the plural cell FET of FIG. 4A, such cross section being taken along line 4B-4B in FIG. 4A according to the PRIOR ART;
FIG. 4C is a cross sectional view of the plural cell FET according to the PRIOR ART;
FIG. 4D is a cross sectional view of the plural cell FET according to the PRIOR ART;
FIG. 5 is a block diagram of a FET power amplifier having a plurality of the FETs, each one of the FETs having an integrated linearizing diode according to the disclosure;
FIG, 5A is as top view of a FET and integrated linearization diode according to the disclosure;
FIG. 5B ia a cross sectional view of the FET and integrated linearization diode of FIG. 5A according to the disclosure, such cross section being taken along line 5B-5B in FIG. 5A;
FIG. 6A is a simplified top view of a the FET and integrated linearization diode according to an example;
FIG. 6B is a schematic diagram of the FET and integrated linearization diode of FIG. 5A;
FIG. 7 is a simplified top view of a the FET and integrated linearization diode according to an example, such top view having been simplified for purposes of illustration by removing air bridges and a drain manifold contact pad of the FET, a schematic diagram being shown in FIG. 7B;
FIG. 7A is a simplified top view of a the FET and integrated linearization diode according to an example; and
FIG. 7B is a schematic diagram of the FET and integrated linearization diode of FIG. 7A.

Like reference symbols in the various drawings indicate like elements.

### DETAILED DESCRIPTION

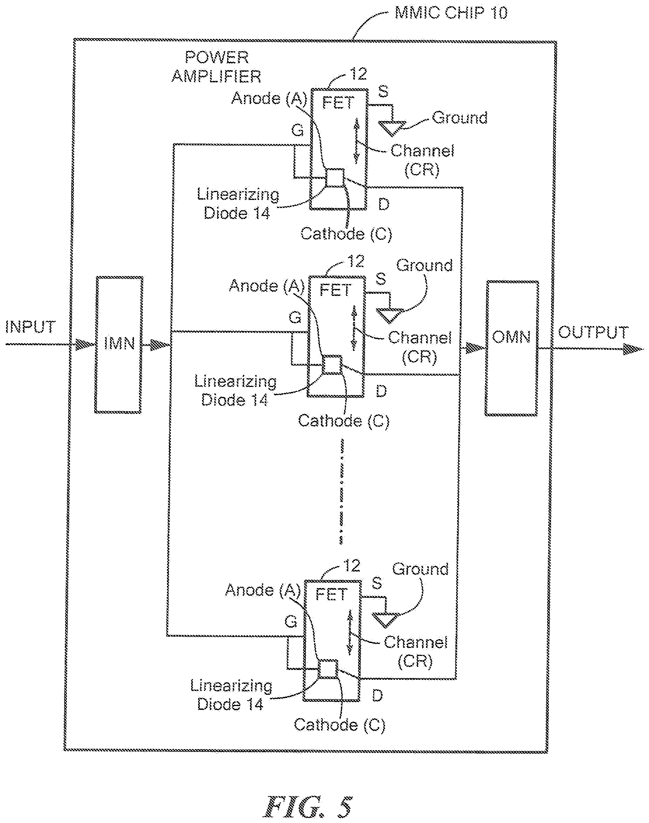

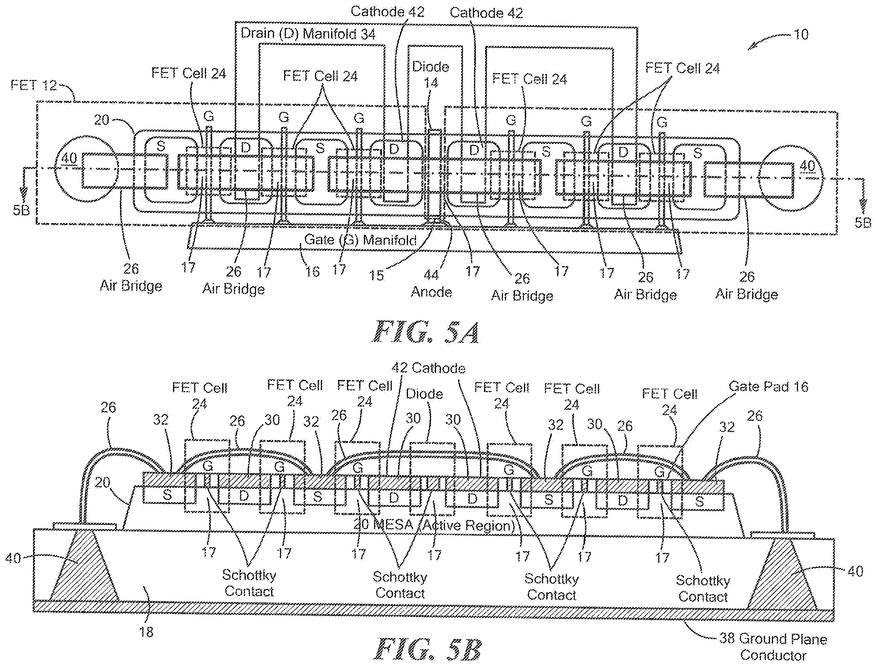

Referring now to FIG. 5 a block diagram is shown of a structure, here a FET MMIC chip power amplifier 10 having: a plurality of field effect transistors FETs 12. Each one of the FETs 12 is identical in construction, an exemplary one thereof being shown in FIGS. 5A and 5B and being described in more detail below. Suffice it to say here that each one of the FETs 12 is associated with it its own linearizing diode 14 connected to the gate electrode G and the drain region (D) of the FET 12. Thus each one of the diodes 14 is associated with, and is proximal to, a corresponding, individual one, of the FETs 12 that requires Cgs vs. Vgs variation compensation.

More particularly, the amplifier 10 includes a MMIC chip structure having the plurality of FETs 12 connected between to a common input through an input impedance matching network (IMN) and a common output through an output impedance matching network (OMN), as shown. Each one of the field effect transistors 12 comprises; a source region (S), a drain region (D), and a gate electrode (G) for controlling carriers through a channel region (CR) of a transistor region of the structure between the source region (S) and the drain region (D). As noted above, each one of the FETs 12 is associated with it its own linearizing diode 14 connected to the gate electrode G and the drain region (D) of the FET 12. More particularly, the diode 14 has an electrode, here the anode (A) of the diode 14, in Schottky contact with a diode region 15 of the FET 12. Here, each one of the FETs 12 is, here in this example, a plural cell FET, an exemplary one thereof being shown in FIGS. 5A and 5B.

Thus, referring now to FIGS. 5A and 5B, an exemplary one of the plural cell FETs 24 is shown along with its associated diode 14 connected between the gate manifold contact pad 16 of the FET 12 and a drain region (D) of the FET 12. More particularly, here the MMIC chip structure includes a substrate 18 having a Group III-V, for example, GaN, semiconductor mesa heterostructure 20 formed on the upper surface of the substrate 18. Here, for example, the mesa structure 20 includes a connectivity to provide an active region for the FET 12. Still more particularly, FET 12 includes a plurality of linearly arranged FET cells 24, here, for example, six, cells 24 interconnected with air bridges 26 as shown. Here, ends of gate finger-like electrodes (G) are connected to the common gate manifold contact pad 16. Each gate finger-like electrodes (G) controls a flow of carriers in a channel region (CR), here indicated by numeral 17, of the active region of the mesa structure 20 between a source region (S) and a drain region (D) of the corresponding one of the cell 24. Drain electrodes 30 are in ohmic -contact with the drain regions (D) of the semiconductor mesa hetero-structure 20; the source electrodes 32 are in ohmic contact with the source regions (S) of the semiconductor mesa hetero-structure 20, and the gate finger-like electrodes (G) are in Schottky contact with the gate regions (G) of the semiconductor mesa hetero-structure 20. The drain electrodes 30 have ends thereof connected to a drain manifold contact pad 34 and the source regions (S) are interconnected by air bridges 26 as shown. In this example, the source regions (S) at the ends of the linear array are also connected to a ground plane conductor 38 on the bottom surface of a substrate 18 with electrically conductive vias 40, as shown.

The diode 14 has a cathode electrode 42 in ohmic contact with a different portion of the of the semiconductor mesa hetero-structure 20, as diode region 15, to provide a cathode for the diode 14. The ohmic contact for the cathode elect ride 44 is formed at the same time as the ohmic contacts for the source and drain electrodes. That is the diode 14 is formed in the mesa 20 between the drain regions D of a pair of adjacent cells 24, here between the central pair of adjacent cells 24. More particularly, the cathode electrode (C), here indicated by numeral 42, of the diode 14 is electrically connected to the drain region D of one of the adjacent cells 24 and the drain region D of the other one of the adjacent cells through portions of the semiconductor region of the mesa 20 between the drain regions D of the adjacent cells 24. An anode electrode 44 of the diode 14 is in Schottky contact with the semiconductor mesa hetero-structure 20 and provides an anode (A) for the diode 14 and is connected to the gate manifold contact pad 16. Thus, the FET gate and the diode anode share a common node. The anode electrode 44 of the diode 14 is disposed along a line parallel to the gate finger-like electrodes G. The source regions, S, the drain regions, D, the channel regions 17, and the diode region 15 are disposed along a common line or direction, here a horizontal direction in FIG. 4A. The gate finger-like electrodes G and the cathode electrode 42 extend along parallel lines and wherein the common line is perpendicular to the parallel lines. Thus, the finger-like gate electrodes G and the cathode electrode 42 are parallel and are in the vertical direction in FIG. 4A.

Referring again to FIGS. 5A and 5B, it is noted that the anode electrode 44 of the diode 14, which is in Schottky contact with the with the semiconductor mesa hetero-structure 20, is much wider than the width of the gate finger-like electrodes G, which are also with the semiconductor mesa hetero-structure 20; here for example 10 to 100 times greater. Therefore, the diode 14 therefore provides a sufficiently large non-linear capacitance between the gate manifold contact pad 14 of the FET 12 and the drain manifold contact pad 34 of the FET 12 to completely balance out the larger Cgs variation with Vgs. Thus, the inventors have made the width of the anode 44 of the diode 14, and hence its anode to cathode capacitance sufficiently large to completely compensate for the gate to source capacitance of the FET. It is also noted that while the width of the anode electrode 44 of the diode 14 and the width of the finger-like gate electrodes G are different, the anode electrode 44 and the finger-like gate electrodes G are formed during the same, common, process step (the anode electrode 44 and the finger-like gate electrodes G are formed concurrently) and thus is formed integrally with the FET 12.

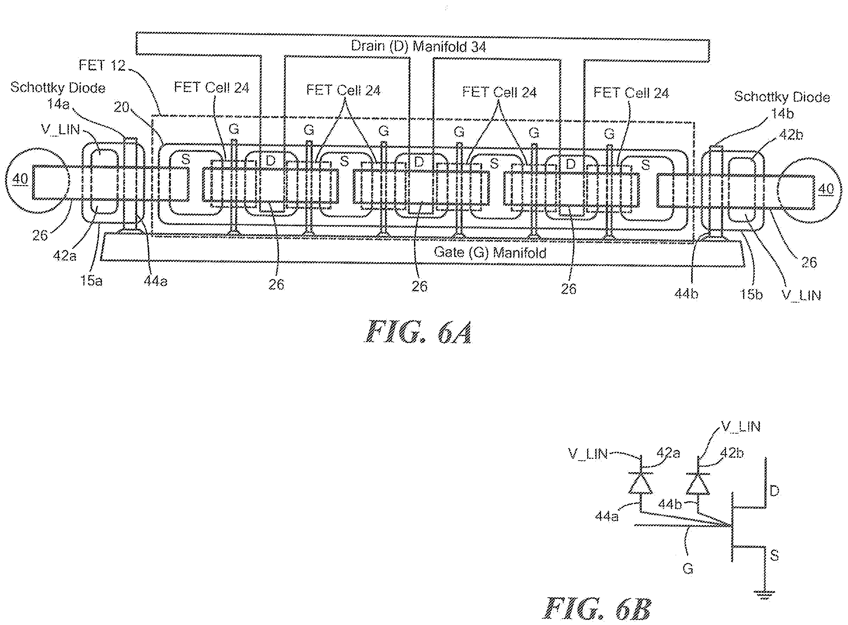

Referring now to FIGS. 6A and 6B, an example is shown. Here, the linearizing diodes 14a, 14b are placed at the ends of the FET 12 and are adapted for the cathode electrodes 42a, 42b of the diodes 14a, 14b to be connected to something other than the drain manifold contact pad 34 of the FET. Here, for example a separate cathode bias voltage called V_LIN that is independent of the transistor drain. The structure is shown schematically in FIG. 6B Here the diodes 14a, 14b are shown formed in semiconductor diode regions 15a, 15b, respectively, spaced from the mesa of the semiconductor FET region having formed therein the FET. It is noted that each of the diodes 14a, 14b have their anode electrode 44a, 44b, which make Schottky contact with of semiconductor diode regions 15a, 15b, respectively, connected to the gate manifold contact pad 16 and have their cathodes electrodes 42a, 42b making ohmic contact to the semiconductor diode regions 15a, 15b, respectively. It is noted that here the anode electrodes 44a, 44b are connected to the gate bus 16; thus, here the FET gate and the diode cathode share a common node. It is noted that the cathodes 42a, 42b can be connected to an independent voltage such as a linearizing voltage V_LIN. Here again, the diode anode electrodes 44a, 44b and the finger-like gate electrodes G are formed during the same process step. Thus, the diode anode electrode 44a, 44b and the finger-like gate electrodes G are formed concurrently. It is noted that the drain regions (D) are connected to the drain (D) manifold pad 34 through drain fingers that pass under the air-bridges 26 connecting the source regions (S).

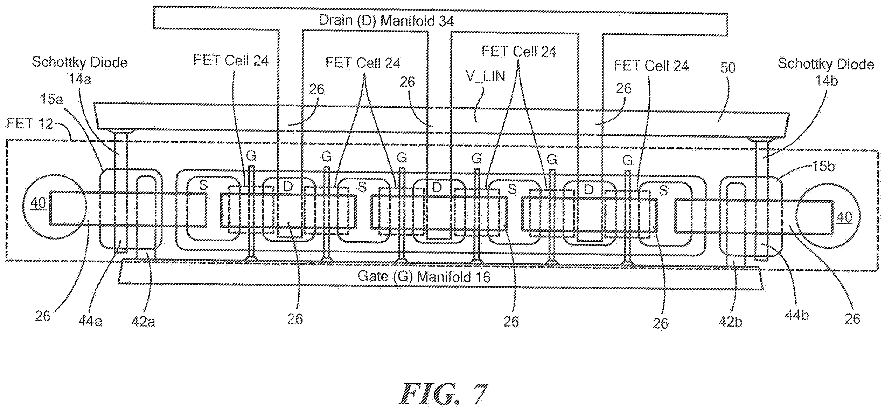

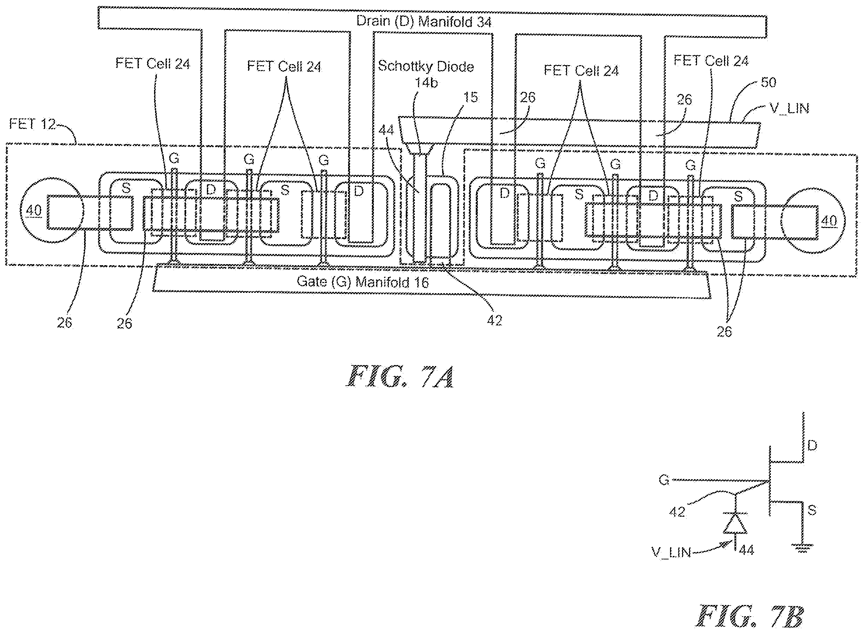

Referring now to FIG. 7, the linearizing diodes 14a, 14b are placed at the ends of the FET 12 and are adapted for the anodes electrodes 44a, 44b of the diodes 14a, 14b to be connected to something other than the gate of the FET; for example, an independent linearizing network which supplies a voltage, here V_LIN connected to a voltage bus 50. Here the diodes 14a, 14b are shown formed in semiconductor diode regions 15a, 15b, respectively, again, as in FIG. SA and 5B spaced from the semiconductor FET region (mesa 20) having formed therein the FET 14. It is noted that each of the diodes 14a, 14b have their anode electrodes 44a, 44b, which make Schottky contact to the semiconductor diode regions 15a, 15b, respectively, connected to a bus 50 adapted for connection to the linearizing network supplying voltage V_LIN and have their cathode electrodes 42a, 42b making ohmic contact to the semiconductor diode regions 15a, 15b, respectively. Here, the cathode electrodes 42a, 42b of the diodes are connected to the gate bus 16; thus here the FET gate and diode cathode share a common node. It is noted that the anode electrodes 44a, 44b and the finger-like gate electrodes G are formed during the same process step. It is noted that the drain regions (D) are connected to the drain (D) manifold pad 34 through drain fingers that pass over the voltage bus 50 and under the air-bridges 26 connecting the source regions (S).

Referring now to FIGS. 7A and 7B, a diode 14 is formed in a diode region 15 between a pair of the cells 14 of the FET. Here the anode electrode 44 of the diode 14 is in Schottky contact with a semiconductor of diode region 15 and is connected to something other than the gate manifold contact pad of the FET; for example, an independent linearizing network providing voltage V_LIN through a bus 50. It is noted that the anode electrodes 44, makes Schottky contact to the semiconductor diode region 15. It is noted that here, the cathode electrode 42 is connected to the gate bus 16. It is again noted that the anode electrode 44 and the finger-like gate electrodes G are formed during the same process step. A schematic diagram of the structure shown in FIG. 7A is shown in FIG. 7B. It is noted that the drain regions (D) are connected to the drain (D) manifold pad 34 through drain fingers that pass over the voltage bus 50 and under the air-bridges 26 connecting the source regions (S).

## Claims

1. A FET MMIC chip power amplifier (10), comprising:
a plurality (12) of field effect transistor, FET, cells configured to receive and amplify an RF input signal, each FET cell (24) of the plurality (12) of FET cells comprising:
a source region (S), a drain region (D), and a gate electrode (G) configured to receive said RF input signal and to control carriers through a channel region (17) of a semiconductor region of the FET MMIC chip power amplifier between the source region (S) and the drain region (D);
wherein the gate electrodes (G) of the plurality (12) of FET cells are parallel one to another; and
wherein the gate electrode (G) of each FET cell (24) has one end connected to a common gate manifold contact pad (16);
drain electrodes (30) in ohmic contact with the drain regions of the plurality (12) of FET cells,
wherein the drain electrodes (30) have ends thereof connected to a drain manifold contact pad (34);
the plurality (12) of FET cells further comprising a linearizing diode (14) having:
a cathode electrode (42) consisting of a first drain electrode of the drain electrodes in ohmic contact with a first drain region of one FET cell (24) of the plurality (12) of FET cells and a second drain electrode of the drain electrodes in ohmic contact with a second drain region of an adjacent FET cell (24) of the plurality (12) of FET cells to provide a cathode for the linearizing diode (14), the linearizing diode (14) being disposed between said first and second drain region, said cathode electrode (42) being connected to the drain manifold contact pad (16);
an anode electrode (44) in Schottky contact with a diode region (15) of the semiconductor region between said first and second drain region and disposed along a line parallel to the gate electrodes to provide an anode for the linearizing diode (14), said anode electrode (44) being connected to the common gate manifold contact pad (16);
the linearizing diode (14) being configured to compensate a non-linear gate to source capacitance, Cgs, versus gate to source voltage, Vgs, variation of the plurality (12) of FET cells.

## Patentansprüche

1. FET-MMIC-Chip-Leistungsverstärker (10), der Folgendes umfasst:
eine Vielzahl (12) von Feldeffekttransistor-Zellen, bzw. FET-Zellen, ausgelegt zum Empfangen und Verstärken eines HF-Eingangssignals, wobei jede FET-Zelle (24) der Vielzahl (12) von FET-Zellen Folgendes aufweist:
eine Source-Region (S), eine Drain-Region (D) und eine Gate-Elektrode (G), ausgelegt zum Aufnehmen des HF-Eingangssignals und zum Steuern von Trägern durch eine Kanalregion (17) einer Halbleiterregion des FET-MMIC-Chip-Leistungsverstärkers zwischen der Source-Region (S) und der Drain-Region (D);
wobei die Gate-Elektroden (G) der Vielzahl (12) von FET-Zellen zueinander parallel sind; und
wobei ein Ende der Gate-Elektrode (G) von jeder FET-Zelle (24) mit einer gemeinsamen Gate-Kontaktfeldmannigfaltigkeit (16) verbunden ist;
Drain-Elektroden (30) in ohmschem Kontakt mit den Drain-Regionen der Vielzahl (12) von FET-Zellen stehen, wobei Enden der Drain-Elektroden (30) mit einer Drain-Kontaktfeldmannigfaltigkeit (34) verbunden sind;
wobei die Vielzahl (12) von FET-Zellen ferner eine Linearisierungsdiode (14) umfasst, die Folgendes aufweist:
eine Kathodenelektrode (42), die aus einer ersten Drain-Elektrode der Drain-Elektroden, die sich in ohmschem Kontakt mit einer ersten Drain-Region von einer FET-Zelle (24) der Vielzahl (12) von FET-Zellen befindet, und einer zweiten Drain-Elektrode der Drain-Elektroden, die sich in ohmschem Kontakt mit einer zweiten Drain-Region von einer angrenzenden FET-Zelle (24) der Vielzahl (12) von FET-Zellen befindet, besteht, um eine Kathode für die Linearisierungsdiode (14) bereitzustellen, wobei die Linearisierungsdiode (14) zwischen der ersten und der zweiten Drain-Region angeordnet ist, wobei die Kathodenelektrode (42) mit der Drain-Kontaktfeldmannigfaltigkeit (16) verbunden ist;
eine Anodenelektrode (44), in Schottky-Kontakt mit einer Diodenregion (15) der Halbleiterregion zwischen der ersten und der zweiten Drain-Region und entlang einer zu den Gate-Elektroden parallelen Linie angeordnet, um eine Anode für die Linearisierungsdiode (14) bereitzustellen, wobei die Anodenelektrode (44) mit der gemeinsamen Gate-Kontaktfeldmannigfaltigkeit (16) verbunden ist;
wobei die Linearisierungsdiode (14) ausgelegt ist zum Kompensieren einer nichtlinearen Gate-Source-Kapazität, Cgs, gegenüber einer Gate-Source-Spannungsvariation bzw. Vgs-Variation, der Vielzahl (12) von FET-Zellen.

## Revendications

1. Amplificateur de puissance (10) à puce à FET MMIC, comprenant :
une pluralité (12) de cellules à transistor à effet de champ, FET, configurées pour recevoir et amplifier un signal d'entrée RF, chaque cellule à FET (24) de la pluralité (12) de cellules à FET comprenant :
une zone de source (S), une zone de drain (D), et une électrode de grille (G) configurée pour recevoir ledit signal d'entrée RF et pour commander des porteurs à travers une zone de canal (17) d'une zone semi-conductrice de l'amplificateur de puissance à puce à FET MMIC entre la zone de source (S) et la zone de drain (D) ;
les électrodes de grille (G) de la pluralité (12) de cellules à FET étant parallèles les unes aux autres ; et
l'électrode de grille (G) de chaque cellule à FET (24) ayant une extrémité connectée à une plage de contact de collecteur de grille commune (16) ;
des électrodes de drain (30) en contact ohmique avec les zones de drain de la pluralité (12) de cellules à FET,
les électrodes de drain (30) ayant leurs extrémités connectées à une plage de contact de collecteur de drain (34) ;
la pluralité (12) de cellules à FET comprenant en outre une diode linéarisante (14) ayant :
une électrode de cathode (42) constituée d'une première électrode de drain des électrodes de drain en contact ohmique avec une première zone de drain d'une cellule à FET (24) parmi la pluralité (12) de cellules à FET et une deuxième électrode de drain des électrodes de drain en contact ohmique avec une deuxième zone de drain d'une cellule à FET adjacente (24) de la pluralité (12) de cellules à FET pour fournir une cathode pour la diode linéarisante (14), la diode linéarisante (14) étant disposée entre lesdites première et deuxième zones de drain, ladite électrode de cathode (42) étant connectée à la plage de contact de collecteur de drain (16) ;
une électrode d'anode (44) en contact de type Schottky avec une zone de diode (15) de la zone semi-conductrice entre lesdites première et deuxième zones de drain et disposée le long d'une ligne parallèle aux électrodes de grille pour fournir une anode pour la diode linéarisante (14), ladite électrode d'anode (44) étant connectée à la plage de contact de collecteur de grille commune (16) ;
la diode linéarisante (14) étant configurée pour compenser une variation de capacitance grille-source non linéaire, Cgs, par rapport à la tension grille-source, Vgs, de la pluralité (12) de cellules à FET.
